# EUROPÄISCHE PATENTSCHRIFT

(11) **EP 0 548 092 B1**
(45) Veröffentlichungstag und Bekanntmachung des Hinweises auf die Patenterteilung: **27.07.1994**
(21) Anmeldenummer: 91914516.9
(22) Anmeldetag: 21.08.1991
(51) Int. Cl.: H03K 17/615

(54) **DARLINGTON-SCHALTUNG MIT MITTELN ZUR ERFASSUNG EINER LEITUNGSUNTERBRECHUNG IN IHREM LASTKREIS**
DARLINGTON CIRCUIT WITH MEANS FOR DETECTING A BROKEN CONDUCTOR IN ITS LOAD CIRCUIT
CIRCUIT DE DARLINGTON AVEC DISPOSITIFS POUR LA DETECTION D'UNE COUPURE DANS SON CIRCUIT DE CHARGE

(30) Priorität: 14.09.1990 DE 4029169
(43) Veröffentlichungstag der Anmeldung: 30.06.1993
(73) Patentinhaber: ROBERT BOSCH GMBH, 70442 Stuttgart (DE)
(72) Erfinder: MICHEL, Hartmut, D-7410 Reutlingen (DE)
(86) Internationale Anmeldenummer: DE9100666
(87) Internationale Veröffentlichungsnummer: WO9205635

(56) Entgegenhaltungen:
- US-A- 4 764 688
- EDN ELECTRICAL DESIGN NEWS, Bd.31, nr.14, 10 Juli 1986, Newton Massachusetts US, Seiten 74-84; Travis: "High-voltage circuits use mixed processes, fulfill diverse roles"

## Beschreibung

### Stand der Technik

Die Erfindung betrifft eine Darlington-Schaltung mit Mitteln zur Erfassung einer Leitungsunterbrechung in ihrem Lastkreis.

Bei Leistungstransistoren, insbesondere bei Darlington-Schaltungen, ist es oft erforderlich, eine Unterbrechung der Verbindungen und Leitungen im Lastkreis feststellen zu können, um entsprechende Gegenmaßnahmen oder Hilfsmaßnahmen einleiten zu können. In bekannter Weise wird hierzu ein Meßwiderstand verwendet, der vom Laststrom oder von einem Teil desselben durchflossen wird. Um die am Meßwiderstand erzeugte Verlustleistung so klein wie möglich zu halten, weist dieser in der Regel einen sehr geringen Widerstandswert auf, so daß der Nennstrom bei ordnungsgemäßem Zustand nur einen geringen Spannungsabfall und eine geringe Verlustleistung erzeugt. Auch für diejenigen Fälle, in denen ein sehr kleiner Teil des Hauptstroms durch den Meßwiderstand fließt, wird häufig trotzdem ein nur geringer Spannungsabfall gefordert, um die Verhältnisse im Haupt- und im Meßpfad nicht zu unterschiedlich zu machen.

Eine Vorrichtung zur Erkennung einer derartigen Leitungsunterbrechung muß auch noch bei Stromwerten sicher ansprechen, die weit unter dem Nennwert liegen, häufig sogar mehrere Größenordnungen unter diesem. Hierdurch werden die auszuwertenden Spannungen extrem klein und die notwendige Meßtechnik sehr aufwendig und teuer.

US-A-4 764 688 offenbart eine Darlington-Schaltung mit einem Endtransistor und einem Vorstufentransistor, einem Widerstand parallel zur Basis-EmitterStrecke des Endtransistors und mit Schaltmitteln zur Erkennung eines Stromflusses im Lastkreis, die von der am Widerstand abfallenden Spannung gesteuert werden und bei Überschreiten eines vorgebbaren Wertes ihren Schaltzustand ändern. Wird ein Stromfluß im Lastkreis festgestellt, ist also der Endtransistor leitend gesteuert, so wird dem Endtransistor ein zusätzlicher Basisstrom einprägt.

### Vorteile der Erfindung

Die erfindungsgemäße Darlington-Schaltung mit den kennzeichnenden Merkmalen des Anspruchs 1 hat den Vorteil, daß eine Leitungsunterbrechung im Lastkreis mit sehr geringem Schaltungs- und damit Kostenaufwand erfaßt werden kann und daß kein Meßwiderstand im Lastkreis oder in einem Nebenzweig desselben erforderlich ist, so daß auch keine Verlustleistung entsteht. Trotz dem einfachen Aufbau mit kostengünstigen Bauteilen, die auch auf einfache Weise monolithisch integrierbar sind, können Leitungsunterbrechungen sehr exakt erfaßt werden.

Durch die in den abhängigen Ansprüchen aufgeführten Maßnahmen sind vorteilhafte Weiterbildungen und Verbesserungen der im Anspruch 1 angegebenen Darlington-Schaltung möglich.

Als Schaltmittel ist im einfachsten Fall ein weiterer Transistor vorgesehen, dessen Basis mit der Basis des Endtransistors der Darlington-Schaltung verbunden ist. Die gesamte Meßvorrichtung zur Erfassung einer Leitungsunterbrechung besteht daher aus einem einzigen Transistor und einem einzigen Widerstand, der nur für sehr geringe Belastungen ausgelegt werden muß.

Eine einfache und zweckmäßige Beschaltung dieses insbesondere als npn-Transistor ausgebildeten weiteren Transistors besteht darin, daß dessen Emitter mit dem Emitter des Endtransistors der Darlington-Schaltung verbunden ist. Der Kollektor dieses weiteren Transistors wird dabei in vorteilhafter Weise von einer Spannungsquelle beaufschlagt, wobei das Kollektorpotential bei ordnungsgemäßem Zustand ohne Vorliegen einer Leitungsunterbrechung auf das niedrige Niveau des Emitterpotentials ("LOW") abgesenkt ist. Hierdurch kann auf einfachste Weise eine Leitungsunterbrechung durch Schaltungsmittel erkannt werden, die auf hohe Potentiale ("HIGH") an der Basis der Darlington-Schaltung und gleichzeitig am Kollektor des weiteren Transistors ansprechen.

Besonders günstig liegen die Verhältnisse bei Verwendung einer wenigstens 3-stufigen Darlington-Schaltung. Da dort mit sehr kleinen Basisströmen gearbeitet wird, kann der parallel zur Basis-Emitter-Strecke des Endtransistors der Darlington-Schaltung liegende Widerstand einen höheren Widerstandswert aufweisen.

Oft liegen Schaltungsbedingungen vor, bei denen eine Darlington-Schaltung über einen vorgeschalteten Emitterfolger mit Basisstrom gespeist wird. Hierbei könnte ein beachtlicher Basisstrom über die Basis-Emitter-Strecke des Eingangstransistors der Darlington-Schaltung fließen, der unter Umständen die Erkennung der Lastunterbrechung nicht zulassen könnte. Um dem zu begegnen, wird zweckmäßigerweise ein den Basisstrom zur Basis des Emitterfolgers bei Vorliegen einer Leitungsunterbrechung gegen den Wert Null absenkender Hilfstransistor vorgesehen, der vom Kollektorpotential der Darlington-Schaltung steuerbar ist. Durch die Absenkung dieses Basisstroms im Falle einer Leitungsunterbrechung kann die vorstehend beschriebene Anordnung wieder uneingeschränkt wirksam werden.

Eine günstige schaltungsmäßige Ausgestaltung kann dadurch erfolgen, daß die Schaltstrecke des Hilfstransistors zwischen die Basis des Emitterfolgers und den Emitter der Darlington-Schaltung geschaltet wird. Zur Ansteuerung ist diesem Hilfstransistor zweckmäßigerweise ein pnp-Vorschalttransistor vorgeschaltet, dessen Schaltstrecke den Emitter des Emitterfolgers mit der Basis des Hilfstransistors verbindet und dessen Basis an den Kollektor der Darlington-Schaltung angeschlossen ist. Bei dieser Schaltungsanordnung werden lediglich zwei zusätzliche Transistoren benötigt, um auch im Falle eines vorgeschalteten Emitterfolgers eine einwandfreie Erkennung einer Leitungsunterbrechung sicherzustellen.

### Zeichnung

Zwei Ausführungsbeispiele der Erfindung sind in der Zeichnung dargestellt und in der nachfolgenden Beschreibung näher erläutert. Es zeigen:
- Fig. 1: ein Schaltbild eines ersten Ausführungsbeispiels mit einer 3-stufigen Darlington-Schaltung und
- Fig. 2: ein Schaltbild eines zweiten Ausführungsbeispiels mit einem Emitterfolger, der einer 2-stufigen Darlington-Schaltung vorgeschaltet ist.

### Beschreibung der Ausführungsbeispiele

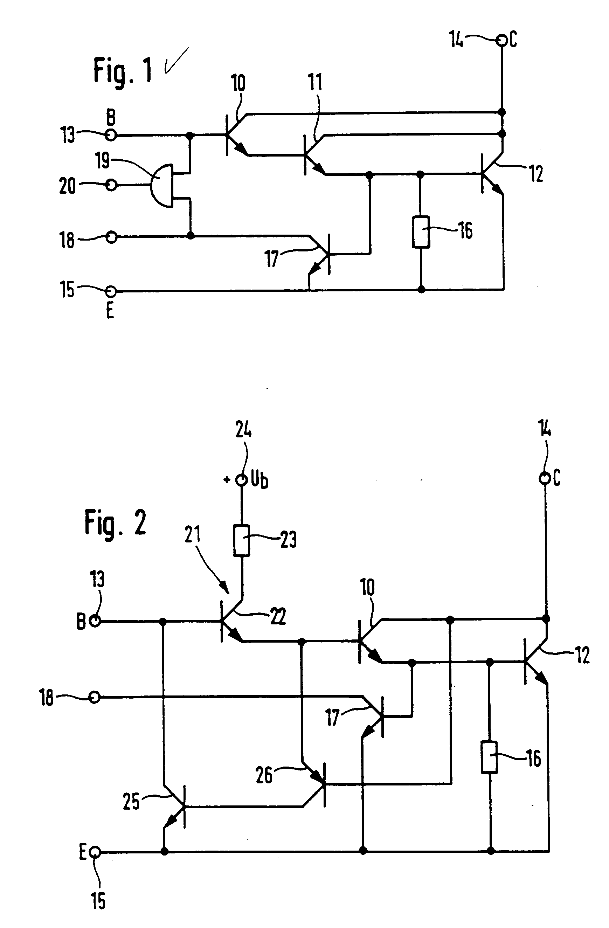

Bei dem in Fig. 1 dargestellten ersten Ausführungsbeispiel besteht eine an sich bekannte 3-stufige Darlington-Schaltung aus zwei Vortransistoren 10,11 und einem Endtransistor 12. Die Basis des ersten Vortransistors 10 ist mit einem Basisanschluß (B) 13 verbunden, während die Kollektoren aller Transistoren 10-12 mit einem Kollektoranschluß (C) 14 verbunden sind. Die Transistoren 10-12 sind als npn-Transistoren ausgebildet. In üblicher Weise ist jeweils der Emitter des ersten Vortransistors 10 mit der Basis des zweiten Vortransistors 11 und dessen Emitter mit der Basis des Endtransistors 12 verbunden, während der Emitter des Endtransistors 12 an einen Emitteranschluß (E) 15 angeschlossen ist.

Zur Erkennung einer Leitungsunterbrechung ist sowohl ein Widerstand 16 als auch die Basis-Emitter-Strecke eines weiteren, als npn-Transistor ausgebildeten Transistors 17 parallel zur Basis-Emitter-Strecke des Endtransistors 12 geschaltet. Der Kollektor des weiteren Transistors 17 ist sowohl mit einer Anschlußklemme 18 als auch mit einem Eingang eines UND-Gatters 19 verbunden, dessen zweiter Eingang an die Basis des ersten Vortransistors 10 angeschlossen ist. Der Ausgang des UND-Gatters 19 ist mit einer Ausgangsklemme 20 verbunden.

Die Wirkungsweise der in Fig. 1 dargestellten Schaltung besteht darin, daß im Normalfall, das heißt, wenn keine Leitungsunterbrechung im Lastkreis, also im Kollektorkreis der Darlington-Schaltung, vorliegt, bei Ansteuerung der Darlington-Schaltung ein Basisstrom in die Basis des ersten Vortransistors 10 fließt und dort einen in Abhängigkeit der Stromverstärkung erhöhten Emitterstrom auslöst. Dieser fließt wiederum als Basisstrom in den zweiten Vortransistor 11 und löst dort einen nochmals verstärkten Emitterstrom aus. Dieser teilt sich auf in einen Betrag, der durch den Widerstand 16 fließt und dort einen Spannungsabfall U_{BE} erzeugt, und in einen zweiten Betrag, der als Basisstrom für den Endtransistor 12 dient und dort einen nochmals infolge der Stromverstärkung erhöhten Strom im Lastkreis veranlaßt. Parallel hierzu wird der weitere Transistor 17 stromleitend gesteuert, so daß das an der Anschlußklemme 18 liegende Potential einer nicht dargestellten Spannungsquelle auf das niedrigere Potential des Emitters abgesenkt wird, also auf das sogenannte "LOW"-Potential. Der Emitter liegt im allgemeinen an Masse.

Ist nun der Lastkreis der Darlington-Schaltung unterbrochen, z.B. infolge einer defekten Leitung, einer schlechten Kontaktstelle oder eines gelösten Anschlusses, so fließt kein Kollektorstrom mehr zu den Vortransistoren 10,11, so daß dort lediglich noch der Basisstrom am Eingang des ersten Vortransistors 10 zur Basis des Endtransistors 12 ohne Verstärkung fließt. Der Spannungsabfall am Widerstand 16 wird dadurch so gering, daß die Transistoren 12 und 17 gesperrt bleiben. An der Anschlußklemme 18 liegt dadurch das höhere Potential der nicht dargestellten Spannungsquelle, und die Anschlußklemme 18 weist dadurch das sogenannte "HIGH"-Potential auf. Da am Basisanschluß 13 ebenfalls ein entsprechendes hohes Potential anliegt, spricht das UND-Gatter 19 an und erzeugt ein Ausgangssignal an der Ausgangsklemme 20, das eine Leitungsunterbrechung signalisiert. Dieses Signal kann in nicht dargestellter Weise beispielsweise ein optisches oder akustisches Signal auslösen oder die Speicherung eines entsprechenden Fehlersignals veranlassen.

Anstelle des UND-Gatters 19 als Mittel zur Erfassung des Fehlerzustands bei einer Leitungsunterbrechung können selbstverständlich auch andere logische Bauelemente eingesetzt werden, die eine entsprechende Signalkombination diagnostizieren können. Dieses UND-Gatter 19 oder ein entsprechendes Bauteil kann entweder zusammen mit der übrigen Schaltung einen monolithisch integrierten Schaltkreis bilden, oder es kann als externes Bauelement vorgesehen sein. Es ist auch möglich, die Anschlußklemme 18 mit einem gegebenenfalls ohnehin vorhandenen Mikrorechner zur Steuerung der Darlington-Schaltung zu verbinden, wobei die Fehlererkennung dann in diesem Mikrorechner erfolgt.

Anstelle der dargestellten 3-stufigen Darlington-Schaltung kann selbstverständlich auch eine 2-stufige Schaltung oder eine Schaltung mit einer noch größeren Anzahl von Stufen treten. Eine größere Anzahl von Stufen erweist sich als günstig, da dann infolge der hohen Stromverstärkung ein Widerstand 16 gewählt werden kann, der einen höheren Widerstandswert aufweist.

Das in Fig. 2 dargestellte zweite Ausführungsbeispiel ist prinzipiell gleich aufgebaut, so daß gleiche oder gleich wirkende Bauteile mit denselben Bezugszeichen versehen und nicht nochmals beschrieben sind.

Die Darlington-Schaltung ist hier als 2-stufige Schaltung ausgebildet, bei der der zweite Vortransistor 11 entfällt. Weiterhin ist dieser Darlington-Schaltung ein Emitterfolger 21 vorgeschaltet, der aus einem npn-Transistor 22 besteht, dessen Basis-Emitter-Strecke zwischen den Basisanschluß 13 und die Basis der Darlington-Schaltung 10,11 geschaltet ist und dessen Kollektor über einen Kollektorwiderstand 23 an den positiven Pol 24 einer Versorgungsspannungsquelle mit der Spannung U_{b} angeschlossen ist.

Zusätzlich ist der Basisanschluß 13 mit dem Emitteranschluß 15 über die Schaltstrecke eines npn-Hilfstransistors 25 verbunden, dem ein pnp-Vorschalttransistor 26 vorgeschaltet ist. Dessen Basis ist an den Kollektor der Darlington-Schaltung angeschlossen, und seine Schaltstrecke verbindet den Emitter des Emitterfolgers 21 mit der Basis des Hilfstransistors 25.

Das hier nicht dargestellte UND-Gatter 19 kann selbstverständlich ebenfalls zur Auswertung entsprechend vorgesehen sein. Andererseits kann die Auswertung auch über die Anschlußklemme 18 und eine daran angeschlossene, nicht dargestellt Auswerteschaltung bzw. einen entsprechend ausgebildeten Mikrorechner erfolgen. Die Auswertebedingungen entsprechen denen des ersten Ausführungsbeispiels.

Wird wie im zweiten Ausführungsbeispiel einer Darlington-Schaltung 10,12 ein Emitterfolger 21 vorgeschaltet, so kann der sich ergebende Strom über die Basis-Emitter-Strecke des Endtransistors 12 bzw. der Spannungsabfall am Widerstand 16 trotz Leitungsunterbrechung so groß werden, daß der Endtransistor 12 und der weitere Transistor 17 aufgesteuert werden. Eine Leitungsunterbrechung könnte dann nicht festgestellt werden. Um dies sicher zu verhindern, sind die Transistoren 25,26 vorgesehen. Bei einer Lastunterbrechung wird der Vorschalttransistor 26 über den Kollektor der Darlington-Schaltung stromleitend gesteuert und steuert wiederum den Hilfstransistor 25 stromleitend, so daß der Basisstrom in die Basis des Emitterfolgers 21 gegen den Wert Null abgesenkt bzw. abgeregelt wird. Hierdurch liegen wieder Verhältnisse vor, wie sie im ersten Ausführungsbeispiel beschrieben sind, so daß der weitere Transistor 17 bei einer Leitungsunterbrechung sicher in den Sperrzustand versetzt wird.

## Patentansprüche

1. Darlington-Schaltung mit einem Endtransistor (12) und mindestens einem Vortransistor (10, 11), einem Widerstand (16) parallel zur Basis-Emitter-Strecke des Endtransistors (12) und mit Schaltmitteln (17), die durch die am Widerstand (16) abfallende Spannung steuerbar sind, dadurch gekennzeichnet, daß die steuerbaren Schaltmittel (17) als Mittel zur Erfassung einer Leitungsunterbrechung im Lastkreis der Darlington-Schaltung herangezogen werden derart, daß beim Absinken der am Widerstand (16) abfallenden Spannung unter einen vorgebbaren Wert die Schaltmittel (17) in einen zweiten, eine Leitungsunterbrechung im Lastkreis kennzeichnenden Schaltzustand versetzbar sind und daß zur Erkennung der Leitungsunterbrechung die Änderung des Schaltzustandes der Schaltmittel (17) durch einen Potentialwechsel an einem Ausgang (18) der Schaltmittel (17) angezeigt wird.

2. Darlington-Schaltung nach Anspruch 1, dadurch gekennzeichnet, daß als Schaltmittel (17) ein weiterer Transistor vorgesehen ist, dessen Basis mit der Basis des Endtransistors (12) der Darlington-Schaltung (10, 11, 12) verbunden ist.

3. Darlington-Schaltung nach Anspruch 2, dadurch gekennzeichnet, daß der weitere Transistor (17) als npn-Transistor ausgebildet ist, dessen Emitter mit dem Emitter des Endtransistors (12) der Darlington-Schaltung (10, 11, 12) verbunden ist.

4. Darlington-Schaltung nach Anspruch 2 oder 3, dadurch gekennzeichnet, daß der Kollektor des weiteren Transistors (17) von einer Spannungsquelle beaufschlagt ist, wobei das Kollektorpotential bei ordnungsgemäßem Zustand ohne Vorliegen einer Leitungsunterbrechung auf das niedrigere Niveau des Emitterpotentials ("LOW") abgesenkt ist.

5. Darlington-Schaltung nach Anspruch 4, gekennzeichnet durch eine logische UND-Verknüpfung (19) des Eingangssignals der Darlington-Schaltung (10, 11, 12) mit dem Ausgangssignal des weiteren Transistors (17).

6. Darlington-Schaltung nach einem der vorhergehenden Ansprüche, dadurch gekennzeichnet, daß eine wenigstens 2-stufige Darlington-Schaltung vorgesehen ist.

7. Darlington-Schaltung nach einem der vorhergehenden Ansprüche, bei der zusätzlich ein Emitterfolger vorgeschaltet ist, dadurch gekennzeichnet, daß ein den Basisstrom zur Basis des Emitterfolgers bei Vorliegen einer Leitungsunterbrechung gegen den Wert Null absenkender Hilfstransistor (25) vorgesehen ist, dessen Schaltstrecke zwischen die Basis des Emitterfolgers (21) und den Emitter der Darlington-Schaltung (10, 11, 12) geschaltet ist, wobei dem Hilfstransistor (25) ein pnp-Vorschalttransistor (26) vorgeschaltet ist, dessen Schaltstrecke den Emitter des Emitterfolgers (21) mit der Basis des Hilfstransistors (25) verbindet und dessen Basis an den Kollektor der Darlington-Schaltung (10, 11, 12) angeschlossen ist.

## Claims

1. Darlington circuit with an output transistor (12) and at least one feed transistor (10, 11), a resistor (16) in parallel with the base-emitter path of the output transistor (12) and with switching means (17) which are controllable by the voltage dropped across the resistor (16), characterized in that the controllable switching means (17) are used as means for detecting a line break in the load circuit of the Darlington circuit, in such a manner that when the voltage dropped across the resistor (16) drops below a predeterminable value, the switching means (17) can be set to a second switching state characterizing a line break in the load circuit and in that, for detecting the line break, the change in the switching state of the switching means (17) is indicated by a potential change at an output (18) of the switching means (17).

2. Darlington circuit according to Claim 1, characterized in that a further transistor, the base of which is connected to the base of the output transistor (12) of the Darlington circuit (10, 11, 12) is provided as switching means (17).

3. Darlington circuit according to Claim 2, characterized in that the further transistor (17) is constructed as an npn-transistor, the emitter of which is connected to the emitter of the output transistor (12) of the Darlington circuit (10, 11, 12).

4. Darlington circuit according to Claim 2 or 3, characterized in that a voltage source is applied to the collector of the further transistor (17), the collector potential being lowered to the lower level of the emitter potential ("LOW") in the correct state without the presence of a line break.

5. Darlington circuit according to Claim 4, characterized by a logical AND combination (19) of the input signal of the Darlington circuit (10, 11, 12) with the output signal of the further transistor (17).

6. Darlington circuit according to one of the preceding claims, characterized in that an at least 2-stage Darlington circuit is provided.

7. Darlington circuit according to one of the preceding claims, in which additionally an emitter follower is connected in incoming circuit, characterized in that an auxiliary transistor (25) lowering the base current to the base of the emitter follower towards the value zero in the presence of a line break is provided, the switching path of which is connected between the base of the emitter follower (21) and the emitter of the Darlington circuit (10, 11, 12), the auxiliary transistor (25) being preceded by a pnp series transistor (26), the switching path of which connects the emitter of the emitter follower (21) to the base of the auxiliary transistor (25), and the base of which is connected to the collector of the Darlington circuit (10, 11, 12).

## Revendications

1. Montage Darlington comprenant un transistor de sortie (12) et au moins un transistor amont (10, 11), une résistance (16) en parallèle au chemin base-émetteur du transistor de sortie (12) et des moyens de commutation (17) commandés par la tension aux bornes de la résistance (16), montage caractérisé en ce que les moyens de commutation commandés (17) sont des moyens pour détecter une coupure de ligne dans le circuit de charge du montage Darlington utilisés de façon qu'en cas de diminution de la tension aux bornes de la résistance (16), en dessous d'une valeur -prédéterminée, les moyens de commutation (17) sont mis dans un second état de commutation caractérisant la coupure de ligne dans le circuit de charge et en ce que pour détecter la coupure de ligne, la variation de l'état de commutation des moyens de commutation (17) est indiqué par un changement de potentiel à une sortie (18) des moyens de commutation (17).

2. Montage Darlington selon la revendication 1, caractérisé en ce que le moyen de commutation (17) est un autre transistor dont la base est reliée à la base du transistor de sortie (12) du montage Darlington (10, 11, 12).

3. Montage Darlington selon la revendication 2, caractérisé en ce que l'autre transistor (17) est un transistor de type npn dont l'émetteur est relié à l'émetteur du transistor de sortie (12) du montage Darlington (10, 11, 12).

4. Montage Darlington selon la revendication 2 ou 3, caractérisé en ce que le collecteur de l'autre transistor (17) est soumis à l'action d'une source de tension , le potentiel du collecteur étant abaissé au niveau le plus bas du potentiel d'émetteur (« BAS ») dans des conditions normales lorsqu'il n'y a pas de coupure de ligne.

5. Montage Darlington selon la revendication 4, caractérisé par une porte logique ET (19) reliant le signal d'entrée du montage Darlington (10, 11, 12) au signal de sortie de l'autre transistor (17).

6. Montage Darlington selon l'une des revendications précédentes, caractérisé par un montage Darlington à au moins deux étages.

7. Montage Darlington selon l'une des revendications précédentes avec en outre un émetteur-suiveur, caractérisé en ce qu'il comporte un transistor auxiliaire (25) qui abaisse vers zéro le courant de base vers la base de l'émetteur-suiveur en cas de coupure de ligne, transistor dont le chemin de commutation est branché entre la base de l'émetteur-suiveur (21) et l'émetteur du montage Darlington (10, 11, 12) , le transistor auxiliaire (25) étant précédé d'un transistor amont (26) de type pnp dont le chemin de commutation relie l'émetteur de l'émetteur-suiveur (21) à la base du transistor auxiliaire (25) et dont la base est reliée au collecteur du montage Darlington (10, 11, 12).
